# EUROPEAN PATENT APPLICATION

(11) **EP 1 341 045 A1**
(43) Date of publication of application: **03.09.2003**
(21) Application number: 03251183.4
(22) Date of filing: 27.02.2003
(51) Int. Cl.: G03F 7/20

(54) **Method of transferring a mask or substrate**

(30) Priority: 01.03.2002 EP 02075883
(71) Applicant: ASML Netherlands B.V., 5503 LA Veldhoven (NL)
(72) Inventor: Heerens, Gert-Jan, 2871 ZH Schoohoven (NL); van de Ven, Bastiaan L.W.M., 5211 GP 's-Hertogenbosch (NL); Lansbergen, Robert G.M., 3121 XR Schiedam (NL); Ham, Erik L., 3011 DK Rotterdam (NL)
(74) Representative: Leeming, John Gerard

(57) **Abstract**

A method for transferring one or more substrates or masks in a storage box to a device or apparatus for handling, processing or using said substrates or masks or vice versa, said storage box (11) comprising a cover having an openable cover part (12). The method comprises providing said storage box onto an openable wall part (21) of a wall of an enclosed protective environment of said device or apparatus such that said openable cover part of said storage box overlaps said openable wall part of said protective environment, said protective environment being adapted to be filled with an inert gas or to be evacuated; opening said openable cover part of said storage box and said openable wall part of said protective environment, whereby said cover of storage box forms part of said wall of said protective environment and an inside of said storage box becomes part of said protective environment; and transferring at least one of said substrates or masks from an inside space of said storage box to an inside space of said wall of said protective environment or vice versa.

## Description

The present invention relates to a method of transferring a substrate or mask suitable for patterning a projection beam of extreme ultraviolet electromagnetic radiation, a storage box, device or apparatus adapted for use in such a method, for instance, a lithographic projection apparatus comprising:
a radiation system for providing the projection beam of extreme ultraviolet electromagnetic radiation;
a mask table for holding the reflective mask, the mask serving to pattern the projection beam according to a desired pattern upon reflection of the projection beam at the mask so as to yield a patterned projection beam;
a substrate table for holding a substrate; and
a projection system for projecting the patterned projection beam onto a target portion of the substrate.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus -each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern *(e.g.* in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, both incorporated herein by reference.

The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. The mask table ensures that the mask can be held at a desired position in the incoming radiation beam, and that it can be moved relative to the beam if so desired.

Conventionally, the mask table has been positioned such that radiation is passed from the illumination system through the mask, the projection system and onto the substrate. Such masks are known as transmissive masks since they selectively allow the radiation from the illumination system to pass through, thereby forming a pattern on the substrate. Such masks must be supported so as to allow the transmission of light therethrough. This has conventionally been achieved by using a vacuum in the table at a perimeter zone of the mask so that the atmospheric air pressure clamps the mask to the table.

In a lithographic apparatus the size of features that can be imaged onto the wafer is limited by the wavelength of the projection radiation. To produce integrated circuits with a higher density of devices, and hence higher operating speeds, it is desirable to be able to image smaller features. Whilst most current lithographic projection apparatus employ ultraviolet light of 365 nm, 248 nm and 193 nm generated by mercury lamps or excimer lasers, it has been proposed to use shorter wavelength radiation of around 13 nm. Such radiation is termed extreme ultraviolet (EUV) radiation and possible sources include laser-produced plasma sources, discharge sources or synchrotron radiation sources, examples of which are, for instance, disclosed in European patent applications EP 1 109 427 A and EP 1 170 982 A, incorporated herein by reference.

Since no materials are known to date to be sufficiently transparent to EUV radiation, a lithographic projection apparatus employing EUV radiation is envisaged to employ a reflective mask having a multilayer coating of alternating layers of different materials, for instance, in the order of 50 periods of alternating layers of molybdenum and silicon or other materials, such as, for instance, disclosed in European patent application EP 1 065 532 A, incorporated herein by reference. The size of the features to be imaged in EUV lithography makes the imaging process very sensitive to any contamination present on the mask. It is foreseen that any contaminant particles having a dimension in the order of 50 nm will result in defects present in devices fabricated in the substrate. Conventionally, the patterned side of the reticle is covered by a so-called pellicle. Any contamination will then accumulate on the pellicle surface at some distance from the mask pattern and will therefore not be (sharply) imaged onto the substrate, making such masks having pellicles less sensitive to contamination. Pellicles cannot be employed for EUV radiation since they will not be sufficiently transparent to EUV radiation. Particle contamination on the pattern-bearing reflective surface of the mask would therefore lead to defective devices fabricated and must be prevented.

Further, the reflective mask is envisaged to be held at its backside on the mask table by electrostatic forces on a mask-bearing surface to be able to meet the very stringent requirements for EUV mask positioning. Any contaminant particles present in between the backside of the mask and the mask-bearing surface of the mask table will result in irregularities of the reflective mask surface. Since the projection system will be non-telecentric on the object side because a reflective mask is used (more information on this problem can be derived from European patent application EP 1 139 176 A, incorporated herein by reference), any irregularity in the surface figure of the reflective mask surface will translate into a local shift of the pattern imaged onto the substrate. As a result, the imaged layer may not line up with earlier layers that have been processed in the substrate, again leading to defective devices fabricated. Therefore, particle contamination on the backside surface of the mask must be prevented.

Molecular type of contamination, such as hydrocarbons and water, should also be prevented. Such contamination will have a detrimental effect on any optical components in the lithographic apparatus, including the mask. In all handling procedures of masks and substrates, care should be taken that their surfaces will remain clean from such molecular contamination. Masks and substrates may be stored and transported in between various types of apparatus employing a storage box in which a protective environment is maintained, such as an environment that is evacuated or filled with an inert gas. Inside walls of such a storage box should also remain clean. However, while transferring a mask or substrate out of such a storage box to a device or apparatus for processing or employing such substrate or mask, contamination, both particulate contamination and molecular contamination may be introduced onto mask or substrate or internal walls of a protective environment. One may transfer a mask or substrate through some intermediate chamber, for instance, a load lock chamber, to a final environment for processing or use, but then it may require very long times before such contamination is removed from the intermediate chamber, for instance, very long pump down times when the protective environment is to be evacuated.

It is an object of the present invention to provide a transferring method in which the introduction of contamination into a protective environment is largely reduced or even fully prevented.

This and other objects are achieved according to the invention in a method for transferring one or more substrates or masks in a storage box to a device or apparatus for handling, processing or using said substrates or masks or vice versa, said storage box comprising a cover having an openable cover part, said method comprising:
providing said storage box onto an openable wall part of a wall of an enclosed protective environment of said device or apparatus such that said openable cover part of said storage box overlaps said openable wall part of said protective environment, said protective environment being adapted to be filled with an inert gas or to be evacuated;
opening said openable cover part of said storage box and said openable wall part of said protective environment, whereby said cover of said storage box forms part of said wall of said protective environment and an inside of said storage box becomes part of said protective environment; and
transferring at least one of said substrates or masks from an inside space of said storage box to an inside space of said wall of said protective environment or vice versa.

According to further aspects of the invention there are provided a storage box and a device or apparatus for use in the above method.

According to yet a further aspect of the invention there is provided a device manufacturing method comprising the steps of:
providing a substrate that is at least partially covered by a layer of radiation-sensitive material;
providing a projection beam of extreme ultraviolet radiation using a radiation system;
using a reflective mask to endow the projection beam with a pattern in its cross-section so as to provide a patterned beam of radiation;
projecting the patterned beam of radiation onto a target portion of the layer of radiation-sensitive material; and
transferring one or more masks or substrates according to the above method.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass extreme ultra-violet (EUV) radiation (*e.g.* having a wavelength in the range 5-20 nm).

Embodiments of the invention will now be described, by way of example only, with reference to the accompanying schematic drawings, in which corresponding reference symbols indicate corresponding parts, and in which:
Figure 1 schematically depicts a lithographic projection apparatus according to an embodiment of the invention;
Figure 2 schematically depicts a storage box in which a mask is stored;
Figure 3 schematically depicts a storage box on a load lock chamber that is attached to a vacuum chamber of the lithographic apparatus of figure 1;
Figure 4 schematically depicts the storage box on the load lock chamber of figure 4, but with the mask lowered into the load lock chamber; and
Figure 5 schematically depicts the storage box and load lock chamber according to figure 4, but with an extra cover over the storage box.

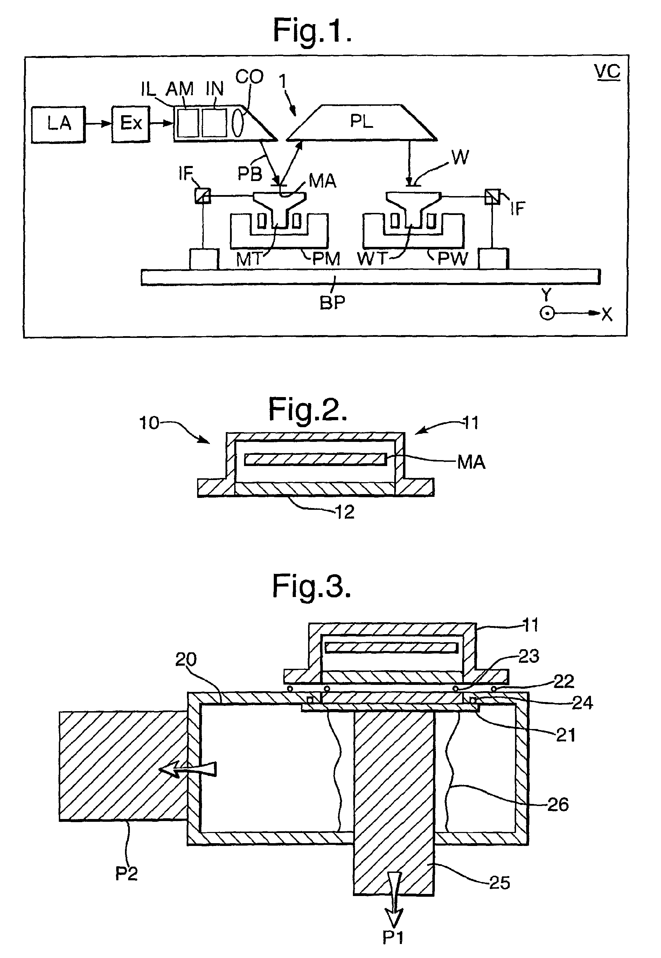

Figure 1 schematically depicts a lithographic projection apparatus according to a particular embodiment of the invention. The apparatus comprises:
a radiation system Ex, IL, for supplying a projection beam PB of EUV radiation *(e.g.* having a wavelength in the range 5-20 nm). In this particular case, the radiation system also comprises a radiation source LA;
a first object table (mask table) MT provided with a mask holder for holding a mask MA *(e.g.* a reticle), and connected to first positioning means PM for accurately positioning the mask with respect to item PL;
a second object table (substrate table) WT provided with a substrate holder for holding a substrate W *(e.g.* a resist-coated silicon wafer), and connected to second positioning means PW for accurately positioning the substrate with respect to item PL;
a projection system ("lens") PL for imaging an irradiated portion of the mask MA onto a target portion C *(e.g.* comprising one or more dies) of the substrate W.

As here depicted, the apparatus is of a reflective type *(i. e.* has a reflective mask). However, in general, it may also be of a transmissive type, for example (with a transmissive mask). Alternatively, the apparatus may employ another kind of patterning means, such as a programmable mirror array of a type as referred to above.

The source LA *(e.g.* laser-produced plasma source or a discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA would be a mercury lamp, for example), but that it may also be remote from the lithographic projection apparatus, the radiation beam which it produces being led into the apparatus *(e.g.* with the aid of suitable directing mirrors); this latter scenario is often the case when the source LA would be an excimer laser. The current invention and claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means PW (and interferometric measuring means IF), the substrate table WT can be moved accurately, *e.g.* so as to position different target portions C in the path of the beam PB. Similarly, the first positioning means PM can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Since EUV radiation will be largely absorbed by most gases and to provide a protective environment to the optical components used, the apparatus is largely contained in a vacuum environment VC, which generally will be divided into several subcompartments.

Figure 2 shows a mask storage box 10, in which an EUV reflective mask is stored for transportation, storage and handling purposes. Storage box 11 comprises a top part 11 and a bottom plate 12. Mask MA is held inside storage box 10 on bottom plate 12, for instance, by a kinematically-determined holding mechanism as disclosed in European patent application EP 01301864.3, incorporated herein by reference. Inside storage box 10 an atmosphere of a protective (inert) gas may be maintained, for instance, at a pressure above ambient pressure. However, a vacuum may also be maintained inside storage box 10. Especially in the latter case, a sufficient sealing is preferably provided in between bottom plate 12 and top part 11 to prevent a gas flow in between the inside of the storage box and its ambient environment and a resulting contaminated inside environment of the storage box.

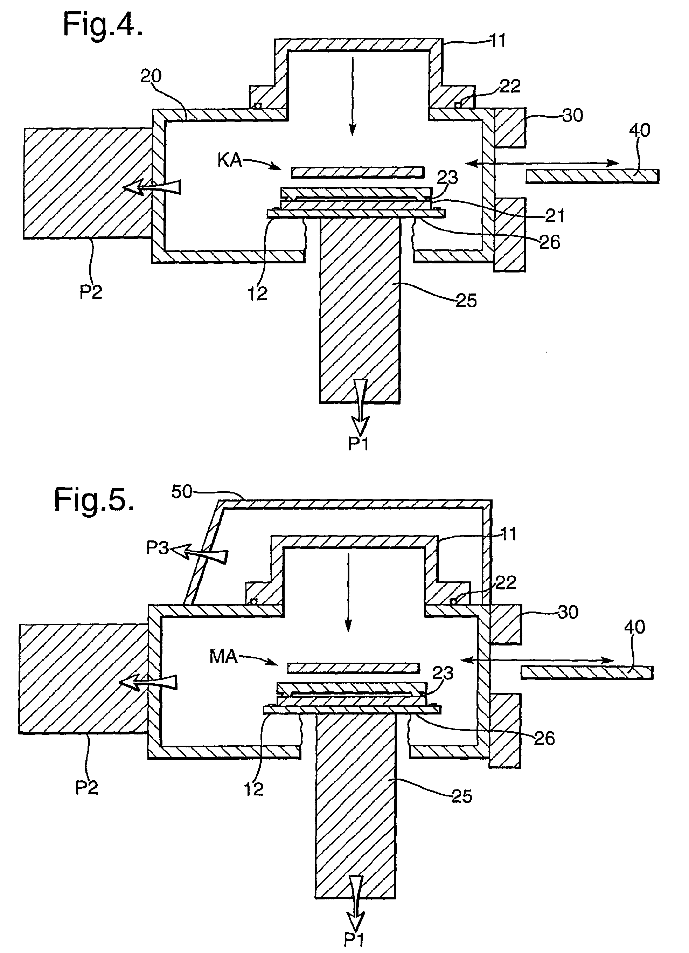

For transferring the mask from storage box 10 to the lithographic projection apparatus, the storage box is put onto a so-called load lock 20, which is shown in figure 3. Load lock 20 will be connected to vacuum environment VC of the lithographic apparatus of figure 1 by a valve 30, which is further shown in figures 4 and 5. Storage box 10 is positioned on load lock 20 such that bottom plate 12 of the storage box exactly overlaps with an openable top part 21 of the load lock. To this end a guiding mechanism (not shown) can be provided on the load lock and/or the storage box to properly align the storage box and the openable top of the load lock. A clamping mechanism (not shown) is preferably provided to clamp the storage box on the load lock when storage box 10 is properly positioned. A seal 22 is schematically shown in between storage box 10 and load lock 20. Seal 22 is preferably provided very close to the bottom plate 12 and openable top 21.

Bottom plate 12 of the storage box and the openable top 21 are now in contact with each other. Cross-sectional shapes of the bottom plate and openable top in a plane perpendicular to the drawing are made so as to have a substantially identical shape. Shapes of contacting surfaces of both elements will therefore match. A seal 23 is preferable provided very close to the circumference in between bottom plate 12 and openable top 21. A pump P1 is preferably provided to be able to evacuate the space in between bottom plate 12 and openable top 21.

Openable top 21 of load lock 20 is seen to be provided on an elevator 25 for moving openable top 21 up and down. A seal 24 is provided for sealing top 21 against the upper wall of load lock 20 when top 25 is moved fully upward against said wall so as constitute a part of it. A bellows 26 is provided around elevator 25 and in between top 21 and a bottom wall of load lock 20. Elevator 25 is connected to appropriate drive means (not shown) for moving it up and down. Another pump P2 is provided for evacuating load lock 20.

For transferring a mask in mask storage box 10 into load lock 20 one may proceed as follows. At first, the mask is held inside its storage box 10. Care will have been taken that all inside walls of the storage box are very clean so as not to contaminate the mask stored inside the box. Both particles and molecular contamination may make the mask useless for patterning the projection beam in the lithographic projection apparatus. As discussed above, a vacuum or an inert gas may be peovided inside the storage box.

Storage box 10 will then be positioned over openable top 21 of load lock 20 as described above. The contaminated outside surface of bottom plate 12 will overlap the contaminated outside surface of openable top 21. The space in between will be evacuated through elevator 25 using vacuum pump P1.

Dependent on an evacuated or gas-filled space inside storage box 10 one may proceed in various ways. In case the storage box is evacuated, it seems prefarable to first evacuate load lock 20 using pump P2 before opening its top 21. In case the storage box is filled with a gas, one may proceed by also first evacuating load lock 20, followed by gently or very suddenly opening top 21 by lowering elevator 25. A gas flow out of the storage box into the load lock will then result, and a sudden gas flow and evacuation of the storage box may help in removing particles that might be present on the mask so as to clean it. Another approach would be to first fill the load lock with an (inert) gas followed by lowering top 21 and then evacuating the load lock using pump P2.

Care will also have been taken that all inside surfaces of the load lock will be very clean. By proceeding as described, the amount of contaminated surface area presented to the combined inside space of load lock and storage box is very limited. Such contaminated surfaces might introduce contamination onto the mask, but would also dramatically increase pump-down times to the partial pressures (for instance of water and hydrocarbons) required for EUV projection lithography.

Figure 4 shows the mask lowered out of its storage box. The figure further shows a side valve 30 connecting the load lock to another part of the vacuum system of the projection apparatus. Valve 30 in its open position allows access of a gripper 40 to pick up the mask and transport to an internal library, the mask table or any other location, as required. A gripper is disclosed in EP 01301864.3, referred to earlier.

For unloading the mask from the projection apparatus into the mask storage box, gripper 40 first puts mask MA onto bottom plate 12 that has been lowered by elevator 25, while the inside space of load lock and storage box is evacuated. Subsequently, valve 30 can be closed. The elevator may then be raised to place the mask into the storage box and to maintain an evacuated space inside the storage box when bottom plate 12 has closed the box. To have an atmosphere of a clean (inert) gas inside the box, the space of load lock and storage box is purged with such gas and subsequently elevator 25 is raised to put mask MA into its storage box and to close it by putting bottom plate 12 in place in the bottom part of the box.

Figure 5 shows a further embodiment of the invention. The figure is identical to figure 4, except that a cover is provided over mask storage box 10 when located on load lock 20. The storage box may not be specifically designed to withstand a pressure induced when the inside of the box is evacuated and the ambient environment of the box is not. By providing cover 50 over the storage box and evacuating both the space inside the storage box and the space in between cover 50 and the storage box, there will be no or only a negligible pressure induced on the storage box. Pump P3 is shown for evacuating the space in between cover 50 and top part 11 of the storage box.

The invention has been described with respect to a lithographic projection apparatus as an example only. The invention may also be employed with any other type of apparatus for handling a mask and in which a mask needs to be loaded from and unloaded into a mask storage box as described, such as a mask writing apparatus, a mask inspection apparatus, a multilayer deposition apparatus, a mask cleaning apparatus, etc. The mask storage box may contain more than one mask in a dedicated holder.

Further, the invention may also be employed in transferring substrates into and out of a storage box for substrates, such as semiconductor wafers processed or to be processed.

The protective environment to which the masks and/or masks are transferred need not be a vacuum environment, but may also be an environment filled with an inert gas, such as dry air, nitrogen, argon, etceteras.

Whilst specific embodiments of the invention have been described above, it will be appreciated that the invention may be practiced otherwise than as described. The description is not intended to limit the invention.

## Claims

1. Method for transferring one or more substrates or masks in a storage box to a device or apparatus for handling, processing or using said substrates or masks or vice versa, said storage box being detachable from said device or apparatus and said storage box comprising a cover having an openable cover part,
**characterized by**,
providing said storage box onto an openable wall part of a wall of an enclosed protective environment of said device or apparatus such that said openable cover part of said storage box overlaps said openable wall part of said protective environment, said protective environment being adapted to be filled with an inert gas or to be evacuated;
opening said openable cover part of said storage box and said openable wall part of said protective environment, whereby said cover of said storage box forms part of said wall of said protective environment and an inside of said storage box becomes part of said protective environment; and
transferring at least one of said substrates or masks from an inside space of said storage box to an inside space of said wall of said protective environment or vice versa.

2. Method according to claim 1, wherein said cover is sealingly provided onto said wall of said protective environment.

3. Method according to claim 1 or 2, wherein opposing outside surfaces of said openable cover of said storage box and said openable wall part of said protective environment are in contact while be opened jointly so as to at least substantially not expose said protective environment to outside surfaces of said cover of said storage box and said wall of said protective environment.

4. Method according to claim 3, wherein said opposing surfaces substantially match.

5. Method according to claim 3 or 4, wherein are sealed at their circumference so as to seal a space in between said opposing surfaces from said protective environment.

6. Method according to any one of the preceding claims, wherein said substrates and/or said masks are for processing and use, respectively, in a lithographic apparatus employing a projection beam of extreme ultraviolet radiation.

7. Storage box adapted for use in a method according to any one of claims 1 to 6.

8. Device or apparatus adapted for use in a method according to any one of claims 1 to 6.

9. Apparatus according to claim 8, wherein said apparatus is lithographic projection apparatus comprising:
a radiation system for providing the projection beam of extreme ultraviolet electromagnetic radiation;
a mask table for holding the reflective mask, the mask serving to pattern the projection beam according to a desired pattern upon reflection of the projection beam at the mask so as to yield a patterned projection beam;
a substrate table for holding a substrate; and
a projection system for projecting the patterned projection beam onto a target portion of the substrate.

10. A device manufacturing method comprising the steps of:
providing a substrate that is at least partially covered by a layer of radiation-sensitive material;
providing a projection beam of extreme ultraviolet radiation using a radiation system;
using a reflective mask to endow the projection beam with a pattern in its cross-section so as to provide a patterned beam of radiation;
projecting the patterned beam of radiation onto a target portion of the layer of radiation-sensitive material; and
transferring one or more masks or substrates according to a method according to any one of claims 1 to 6.
